# EUROPEAN PATENT APPLICATION

(11) **EP 3 989 428 A1**
(43) Date of publication of application: **27.04.2022**
(21) Application number: 21192630.8
(22) Date of filing: 23.08.2021
(51) Int. Cl.: H02M 7/00, H02M 7/493, H02M 1/088, H02M 7/5387

(54) **POWER CONVERSION DEVICE**

(30) Priority: 23.10.2020 JP 2020177761
(71) Applicant: Fuji Electric Co., Ltd., Kawasaki-shi, Kanagawa 210-9530 (JP)
(72) Inventor: TAKANO, Makoto, Kanagawa, 210-9530 (JP)
(74) Representative: Appelt, Christian W.

(57) **Abstract**

In a power conversion device (100), at least one of a positive electrode conductor (30) and a negative electrode conductor (40) is integrally configured in common to at least a plurality of phase semiconductor modules among a semiconductor modules (20) of each phase and is made of aluminum.

## Description

### [Technical Field]

The present invention relates to a power conversion device, and more particularly to a power conversion device including a plurality of semiconductor modules.

### [Background Art]

Conventionally, a power conversion device including a plurality of semiconductor modules is known. Such a power conversion device is disclosed in, for example, JP-A-2016-213945.

JP-A-2016-213945 discloses a power conversion device including a plurality of semiconductor modules housing two switching elements. In addition, capacitors are provided in parallel with the plurality of semiconductor modules. The semiconductor module is provided for each phase. Further, the positive electrode terminal of the capacitor and the positive electrode terminal of the plurality of semiconductor modules are electrically connected by a bus bar (hereinafter referred to as a positive bus bar). Further, the negative electrode terminal of the two capacitors and the negative electrode terminal of the plurality of semiconductor modules are electrically connected by a bus bar (hereinafter referred to as a negative bus bar). In JP-A-2016-213945, both the positive bus bar and the negative bus bar are formed of a copper plate having a substantially U-shape. Additionally, each of the positive bus bar and the negative bus bar is integrally provided in common for the semiconductor module of each phase.

In the conventional power conversion device as disclosed in JP-A-2016-213945, semiconductor modules of each phase may be provided in parallel in order to increase the capacity of the power conversion device. In addition, the number of conductor modules provided in parallel increases according to the capacity of the power conversion device. In this case, as disclosed in JP-A-2016-213945, when each of the positive bus bar and the negative bus bar formed of a copper plate is integrally provided in common for the semiconductor module of each phase, the positive bus bar and the negative bus bar increase in size and weight. Therefore, there is a problem that workability when assembling the power conversion device is deteriorated.

### [Summary of Invention]

The present invention has been made to solve the above-described problems, and one object of the present invention is to provide a power conversion device capable of suppressing deterioration in workability when assembling even in a case where the number of semiconductor modules is increased.

In order to achieve the above object, a power conversion device according to one aspect of the present invention includes a semiconductor module that houses semiconductor elements inside and is provided in plurality for each phase, a capacitor that is electrically connected to the semiconductor module, a positive electrode conductor that is electrically connected to a positive electrode terminal of the capacitor and a positive electrode terminal of the semiconductor module, and a negative electrode conductor that is electrically connected to a negative electrode terminal of the capacitor and a negative electrode terminal of the semiconductor module, in which at least one of the positive electrode conductor and the negative electrode conductor is integrally configured in common to the semiconductor modules of at least a plurality of phases among the semiconductor modules of each phase and is made of aluminum.

In the power conversion device according to one aspect of the present invention, as described above, at least one of the positive electrode conductor and the negative electrode conductor is integrally configured in common to at least a plurality of phase semiconductor modules among the semiconductor modules of each phase and is made of aluminum. As a result, the specific gravity of aluminum is smaller than the specific gravity of copper, so that at least one of the positive electrode conductor and the negative electrode conductor is reduced in weight. As a result, even in a case where the positive electrode conductor and the negative electrode conductor are increased in size due to the increase in the number of semiconductor modules, the increase in the weight of at least one of the positive electrode conductor and the negative electrode conductor is suppressed. Therefore, even in a case where the number of semiconductor modules is increased, it is possible to suppress deterioration in workability when assembling. In addition, since at least one of the positive electrode conductor and the negative electrode conductor is made of aluminum, the power conversion device can be reduced in weight.

Further, since at least one of the positive electrode conductor and the negative electrode conductor is integrally configured in common to the semiconductor module of at least a plurality of phases among the semiconductor modules of each phase, unlike the case where at least one of the positive electrode conductor and the negative electrode conductor is provided separately for each phase, it is possible to suppress an increase in the number of parts.

In the power conversion device according to the above aspect, preferably, both the positive electrode conductor and the negative electrode conductor are integrally configured in common to the semiconductor modules of each phase, and are made by the aluminum. With this configuration, since both the positive electrode conductor and the negative electrode conductor are made of aluminum, the total weight of the positive electrode conductor and the negative electrode conductor can be reduced. As a result, it is possible to further suppress the deterioration in workability when assembling. In addition, the power conversion device can be reduced in weight.

In the power conversion device according to the above aspect, preferably, both the positive electrode conductor and the negative electrode conductor have a flat plate shape, and the positive electrode conductor having the flat plate shape and the negative electrode conductor having the flat plate shape are laminated. With this configuration, a parasitic inductance of the positive electrode conductor and the negative electrode conductor can be reduced by making a direction in which the current flows in the positive electrode conductor and a direction in which the current flows in the negative electrode conductor are opposite to each other.

The power conversion device according to the above aspect preferably further includes output conductors that are electrically connected to an output terminal of the semiconductor module, in which the output conductor has a flat plate shape, is made of aluminum, and is separately provided for each phase, and the positive electrode conductor having the flat plate shape, the negative electrode conductor having the flat plate shape, and the output conductor separately provided for each phase are laminated. With this configuration, in addition to at least one of the positive electrode conductor and the negative electrode conductor, the output conductor is also made of aluminum, so that it is possible to further suppress the deterioration in workability when assembling. In addition, the power conversion device can be further reduced in weight.

The power conversion device according to the above aspect preferably further includes a fuse that is provided between the positive electrode conductor and the capacitor and is common to the semiconductor modules of each phase. With this configuration, the current flowing through the fuse can be reduced as compared with a case where the fuse is provided separately for each phase. As a result, the fuse can be miniaturized.

The power conversion device according to the above aspect preferably further includes a capacitor conductor that is electrically connected to the positive electrode terminal of the capacitor and has a flat plate shape, in which the fuse is connected to the positive electrode conductor and the capacitor conductor. With this configuration, a fuse common to the semiconductor modules of each phase can be easily connected to the capacitor conductor and the positive electrode conductor.

According to the present invention, as described above, even in a case where the number of semiconductor modules is increased, it is possible to suppress the deterioration in workability when assembling.

The foregoing and other objects, features, aspects and advantages of the present invention will become more apparent from the following detailed description of the present invention when taken in conjunction with the accompanying drawings.

### [Brief Description of Drawings]

[Fig. 1] Fig. 1 is a circuit diagram of a power conversion device according to the present embodiment.
[Fig. 2] Fig. 2 is a circuit diagram of a semiconductor module of the power conversion device according to the present embodiment.
[Fig. 3] Fig. 3 is a perspective view of a semiconductor module of the power conversion device according to the present embodiment.
[Fig. 4] Fig. 4 is a perspective view of the semiconductor module and the laminated bus bar according to the present embodiment.
[Fig. 5] Fig. 5 is an exploded perspective view of the laminated bus bar according to the present embodiment.
[Fig. 6] Fig. 6 is a top view of the laminated bus bar, fuse, and capacitor according to the present embodiment.

### [Best Mode for Carrying Out the Invention]

Hereinafter, embodiments embodying the present invention will be described with reference to the drawings.

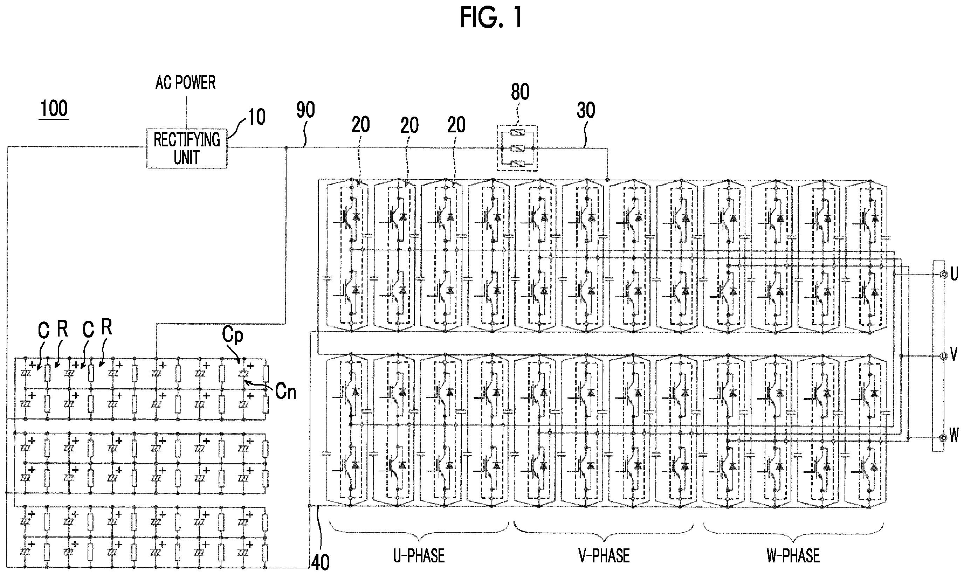

A configuration of a power conversion device 100 according to the present embodiment will be described with reference to Figs. 1 to 6.

As shown in Fig. 1, the power conversion device 100 includes a rectifying unit 10. AC power is input to the rectifying unit 10. The rectifying unit 10 converts the input AC power into DC power.

The power conversion device 100 includes a capacitor C. The capacitor C is configured to smooth the DC power converted to the rectifying unit 10. In addition, the capacitor C is provided between the rectifying unit 10 and the semiconductor module 20. A plurality of capacitors C are provided. The plurality of capacitors C are connected in series with each other, and the capacitors C connected in series are connected in parallel with each other.

The power conversion device 100 includes a resistor R. A plurality of resistors R are provided. The plurality of resistors R are connected in series with each other, and the resistors R connected in series are connected in parallel with each other. In addition, the resistor R connected in series and the capacitor C connected in series are connected in parallel.

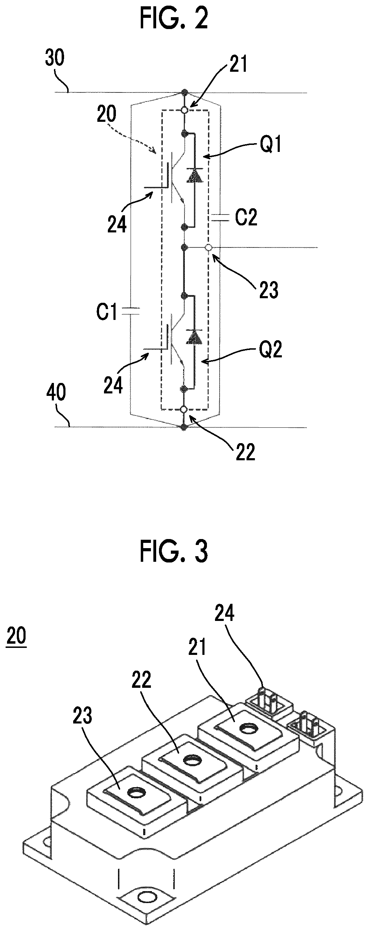

As shown in Figs. 2 and 3, the power conversion device 100 includes a semiconductor module 20. The semiconductor module 20 houses switching elements Q1 and Q2 inside, and is provided in plurality for each phase (U-phase, V-phase, and W-phase). For example, eight semiconductor modules 20 are provided for each phase.

In addition, the semiconductor module 20 includes a C terminal 21 (collector terminal), an E terminal 22 (emitter terminal), an output terminal 23, and a gate terminal 24. Further, a capacitor C1 and a capacitor C2 are provided in parallel with the semiconductor module 20. It should be noted that each of the C terminal 21 and the E terminal 22 is an example of the "positive electrode terminal" and the "negative electrode terminal" in the claims.

In addition, the positive electrode terminal Cp (refer to Fig. 1) of the capacitor C is electrically connected to the C terminal 21 of the semiconductor module 20. Further, the negative electrode terminal Cn (refer to Fig. 1) of the capacitor C is electrically connected to the E terminal 22 of the semiconductor module 20.

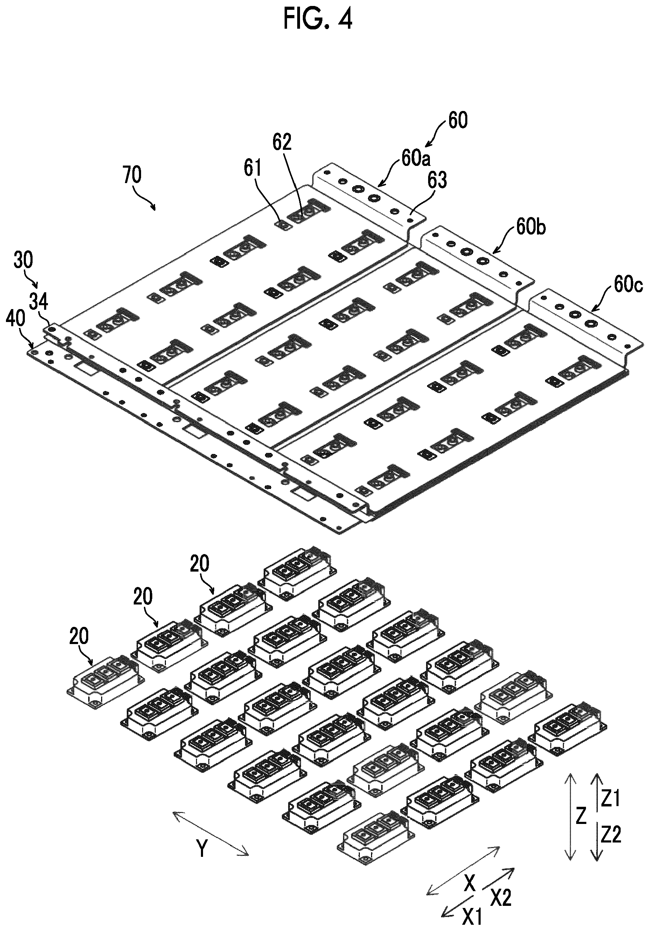

As shown in Fig. 4, the semiconductor modules 20 (twenty-four semiconductor modules 20) of each phase (U-phase, V-phase, and W-phase) are disposed in a matrix (4 rows × 6 columns) of 4 in the X direction and 6 in the Y direction. In addition, the twenty-four semiconductor modules 20 are disposed on a surface of a heat sink (not shown).

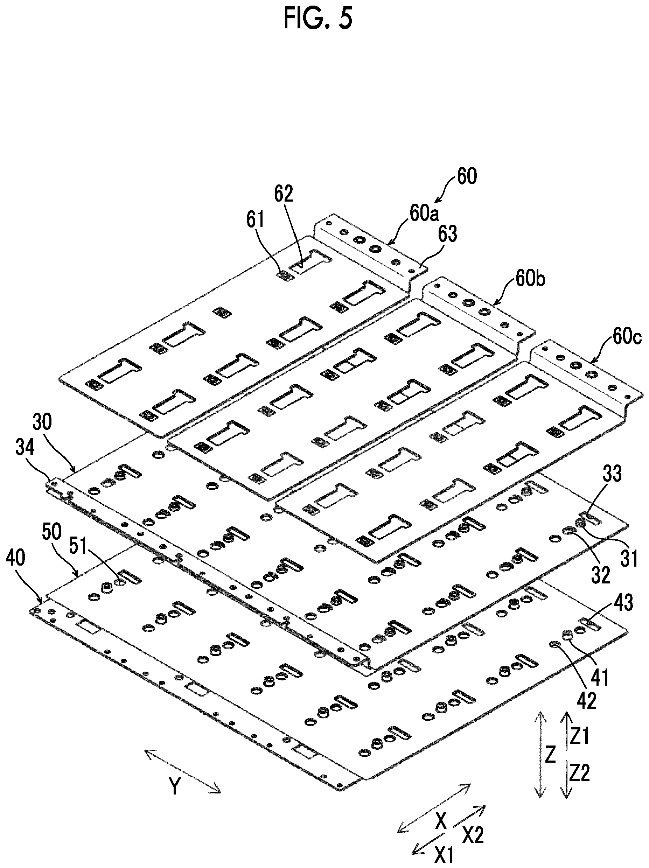

In the present embodiment, as shown in Fig. 5, the power conversion device 100 includes a positive electrode conductor 30 (bus bar) that is electrically connected to the positive electrode terminal Cp of the capacitor C and the C terminal 21 of the semiconductor module 20, and a negative electrode conductor 40 (bus bar) that is electrically connected to the negative electrode terminal Cn of the capacitor C and the E terminal 22 of the semiconductor module 20. At least one (both in the present embodiment) of the positive electrode conductor 30 and the negative electrode conductor 40 is integrally configured in common with the semiconductor modules 20 of at least a plurality of phases (all phases in the present embodiment) of the semiconductor modules 20 of each phase, and is made of aluminum.

The specific gravity of copper is 3.32 times that of aluminum. In addition, a resistance value of copper is 0.63 times a resistance value of aluminum. As a result, in a case where the positive electrode conductor 30 (negative electrode conductor 40) is made of aluminum such that a predetermined amount of current can flow, the weight of the positive electrode conductor 30 (negative electrode conductor 40) is reduced by about half as compared with a case where the positive electrode conductor 30 (negative electrode conductor 40) is made of copper.

In addition, the positive electrode conductor 30 has a flat plate shape. Further, the positive electrode conductor 30 has a substantially rectangular shape. The positive electrode conductor 30 is provided so as to cover the U-phase, V-phase, and W-phase semiconductor modules 20 (twenty-four semiconductor modules 20). Additionally, one positive electrode conductor 30 is provided for each of the twenty-four semiconductor modules 20.

In addition, the positive electrode conductor 30 is provided with a connection terminal 31 connected to the C terminal 21 of the twenty-four semiconductor modules 20. The connection terminal 31 is provided in the positive electrode conductor 30 at a position corresponding to the C terminal 21 of the twenty-four semiconductor modules 20 (immediately above the C terminal 21 of the semiconductor module 20).

In addition, the positive electrode conductor 30 is provided with a hole portion 32 having a circular shape at a position corresponding to the E terminal 22 and the output terminal 23, and a hole portion 33 having a square shape at a position corresponding to the gate terminal 24. The E terminal 22 and the output terminal 23 are exposed on a Z1 direction side via the hole portion 32. The gate terminal 24 is exposed in the Z1 direction via the hole portion 33.

In addition, the end portion 34 of the positive electrode conductor 30 on an X1 direction side has a stepped shape. That is, the positive electrode conductor 30 extends in the X1 direction, extends in the Z1 direction, and then extends in the X1 direction.

In addition, the negative electrode conductor 40 has a flat plate shape. Further, the negative electrode conductor 40 has a substantially rectangular shape. The negative electrode conductor 40 is provided so as to cover the U-phase, V-phase, and W-phase semiconductor modules 20 (twenty-four semiconductor modules 20). Additionally, one negative electrode conductor 40 is provided for each of the twenty-four semiconductor modules 20.

In addition, the negative electrode conductor 40 is provided with a connection terminal 41 connected to the E terminal 22 of the twenty-four semiconductor modules 20. The connection terminal 41 is provided in the negative electrode conductor 40 at a position corresponding to the E terminal 22 of the twenty-four semiconductor modules 20 (immediately above the E terminal 22 of the semiconductor module 20).

Further, the negative electrode conductor 40 is provided with a hole portion 42 having a circular shape at a position corresponding to the C terminal 21 and the output terminal 23, and a hole portion 43 having a square shape at a position corresponding to the gate terminal 24. The C terminal 21 and the output terminal 23 are exposed on the Z1 direction side via the hole portion 42. The gate terminal 24 is exposed in the Z1 direction via the hole portion 43.

In addition, in the present embodiment, the positive electrode conductor 30 having a flat plate shape and a negative electrode conductor 40 having a flat plate shape are laminated. Further, an insulating paper 50 is disposed between the positive electrode conductor 30 and the negative electrode conductor 40. The positive electrode conductor 30 and the negative electrode conductor 40 are insulated by the insulating paper 50. It should be noted that Fig. 5 shows a state in which the insulating paper 50 is disposed on the negative electrode conductor 40. The insulating paper 50 is provided with a hole portion 51 for exposing the connection terminal 41, the C terminal 21, the output terminal 23, and the gate terminal 24.

In addition, in the present embodiment, the power conversion device 100 includes an output conductor 60 (bus bar) that is electrically connected to the output terminal 23 of the semiconductor module 20. The output conductor 60 has a flat plate shape and is made of aluminum. Further, the output conductor 60 (output conductor 60a, output conductor 60b, and output conductor 60c) is provided separately for each phase.

That is, one U-phase output conductor 60a is provided for eight U-phase semiconductor modules 20. The output conductor 60a is provided so as to cover the eight semiconductor modules 20.

In addition, the output conductor 60a is provided with a connection terminal 61 that is connected to the output terminals 23 of the twenty-four semiconductor modules 20. The connection terminal 61 is provided in the output conductor 60a at a position corresponding to the output terminal 23 of the twenty-four semiconductor modules 20 (immediately above the output terminal 23 of the semiconductor module 20).

In addition, the output conductor 60a is provided with a hole portion 62 having a substantially T-shape when viewed from the Z direction at a position corresponding to the C terminal 21, the E terminal 22, and the gate terminal 24 of the semiconductor module 20. The C terminal 21, the E terminal 22, and the gate terminal 24 are exposed from the hole portion 62 in the Z1 direction.

In addition, the end portion 63 of the output conductor 60a on an X2 direction side has a stepped shape. That is, the output conductor 60a extends in the X2 direction, extends in the Z1 direction, and then extends in the X2 direction.

It should be noted that the configuration of the output conductor 60b and the output conductor 60c is the same as the configuration of the output conductor 60a.

In the present embodiment, the positive electrode conductor 30 having a flat plate shape, the negative electrode conductor 40 having a flat plate shape, and the output conductor 60 separately provided for each phase are laminated. The laminated bus bar 70 (refer to Fig. 4) is configured by the laminated positive electrode conductor 30, the negative electrode conductor 40, and the output conductor 60. In addition, the negative electrode conductor 40, the positive electrode conductor 30, and the output conductor 60 are laminated in this order from the Z2 direction side to the Z1 direction side. Further, insulating paper 50 is provided between the negative electrode conductor 40 and the positive electrode conductor 30, and between the positive electrode conductor 30 and the output conductor 60, respectively.

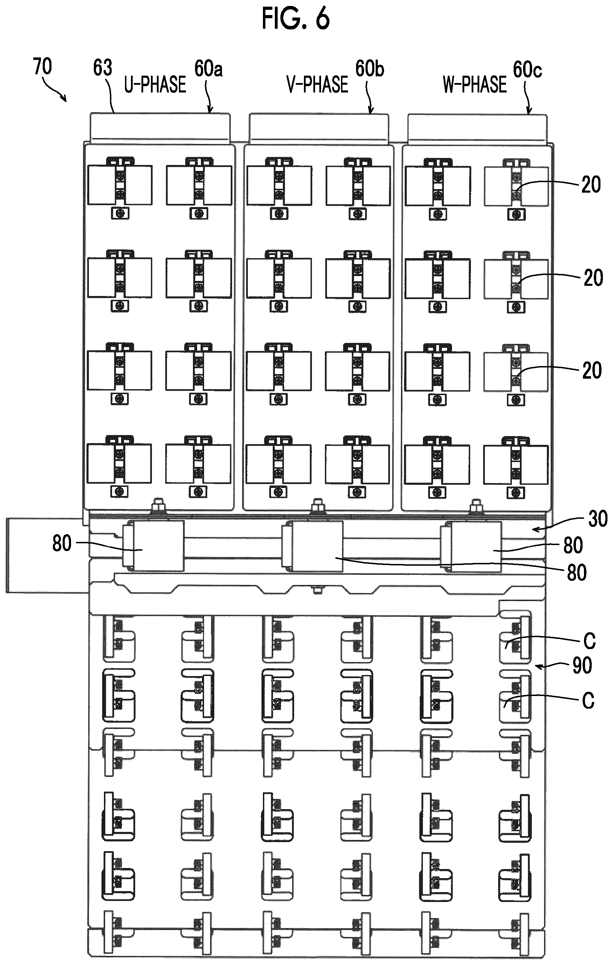

In addition, in the present embodiment, as shown in Fig. 6, the power conversion device 100 includes a fuse 80 that is provided between the positive electrode conductor 30 and the capacitor C, and is common to the semiconductor modules 20 of each phase. A plurality of fuses 80 (three in the present embodiment) are provided in parallel. In addition, the fuse 80 is connected to the conductor 90 (bus bar) and positive electrode conductor 30 that are electrically connected to a plurality of capacitors C and a plurality of resistors R and have a flat plate shape. In addition, the conductor 90 is made of aluminum. Further, the conductor 90 is commonly provided in the plurality of capacitors C and the plurality of resistors R. It should be noted that the conductor 90 is an example of a "capacitor conductor" in the claims.

It should be noted that in a case where the fuse 80 is commonly provided in the semiconductor module 20 of each phase, the current flowing through one fuse 80 is 0.5 times larger than a case where the fuse 80 is provided separately to the semiconductor modules 20 of each phase.

### [Effect of the present embodiment]

In the present embodiment, the following effects can be obtained.

In the present embodiment, as described above, at least one (both in the present embodiment) of the positive electrode conductor 30 and the negative electrode conductor 40 is integrally configured in common with the semiconductor modules 20 of at least a plurality of phases (all phases in the present embodiment) of the semiconductor modules 20 of each phase, and is made of aluminum. As a result, the specific gravity of aluminum is smaller than the specific gravity of copper, so that at least one of the positive electrode conductor 30 and the negative electrode conductor 40 is reduced in weight. As a result, even in a case where the positive electrode conductor 30 and the negative electrode conductor 40 are increased in size due to the increase in the number of semiconductor modules 20, the increase in the weight of at least one of the positive electrode conductor 30 and the negative electrode conductor 40 is suppressed. Therefore, even in a case where the number of semiconductor modules 20 is increased, it is possible to suppress deterioration in workability when assembling. In addition, since at least one of the positive electrode conductor 30 and the negative electrode conductor 40 is made of aluminum, the power conversion device 100 can be reduced in weight.

Since at least one (both in the present embodiment) of the positive electrode conductor 30 and the negative electrode conductor 40 is integrally configured in common with the semiconductor module 20 of at least a plurality of phases (all phases in the present embodiment) among the semiconductor modules 20 of each phase, unlike the case where at least one of the positive electrode conductor 30 and the negative electrode conductor 40 is provided separately for each phase, it is possible to suppress an increase in the number of parts.

In the present embodiment, as described above, both the positive electrode conductor 30 and the negative electrode conductor 40 are integrally configured in common with the semiconductor modules 20 of each phase, and are made by the aluminum. As a result, since both the positive electrode conductor 30 and the negative electrode conductor 40 are made of aluminum, the total weight of the positive electrode conductor 30 and the negative electrode conductor 40 can be reduced. As a result, it is possible to further suppress the deterioration in workability when assembling. In addition, the power conversion device 100 can be reduced in weight.

In the present embodiment, as described above, both the positive electrode conductor 30 and the negative electrode conductor 40 have a flat plate shape, and a positive electrode conductor 30 having the flat plate shape and a negative electrode conductor 40 having the flat plate shape are laminated. As a result, a parasitic inductance of the positive electrode conductor 30 and the negative electrode conductor 40 can be reduced by making a direction in which the current flows in the positive electrode conductor 30 and a direction in which the current flows in the negative electrode conductor 40 are opposite to each other.

In addition, in the present embodiment, as described above, the power conversion device further includes the output conductor 60 that is electrically connected to an output terminal 23 of the semiconductor module 20, in which the output conductor 60 has a flat plate shape, is made of aluminum, and is separately provided for each phase, and the positive electrode conductor 30 having the flat plate shape, the negative electrode conductor 40 having the flat plate shape, and the output conductor 60 separately provided for each phase are laminated. As a result, in addition to at least one of the positive electrode conductor 30 and the negative electrode conductor 40, the output conductor 60 is also made of aluminum, so that it is possible to further suppress the deterioration in workability when assembling. Further, the power conversion device 100 can be further reduced in weight.

In addition, in the present embodiment, as described above, the power conversion device 100 further includes the fuse 80 that is provided between the positive electrode conductor 30 and the capacitor C, and is common to the semiconductor modules 20 of each phase. As a result, the current flowing through the fuse 80 can be reduced as compared with a case where the fuse 80 is provided separately for each phase. As a result, the fuse 80 can be miniaturized.

In addition, in the present embodiment, as described above, the fuse 80 is connected to the positive electrode conductor 30 and the conductor 90. As a result, the fuse 80 common to the semiconductor modules 20 of each phase can be easily connected to the conductor 90 and the positive electrode conductor 30.

### [Modification example]

It should be noted that the embodiments described this time are exemplary in all respects and are not considered to be restrictive. The scope of the present invention is shown by the scope of claims rather than the description of the above-described embodiment, and further includes all modifications (modification examples) within the meaning and scope equivalent to the scope of claims.

For example, in the above embodiment, an example is shown in which both the positive electrode conductor 30 and the negative electrode conductor 40 are made of aluminum, but the present invention is not limited to this. For example, one of the positive electrode conductor 30 and the negative electrode conductor 40 may be made of aluminum, and the other may be made of copper.

In the above embodiment, the positive electrode conductor 30 (negative electrode conductor 40) is integrally configured in common with all the semiconductor modules 20 of the U-phase, V-phase, and W-phase, but the present invention is not limited to this. For example, the U-phase and V-phase positive electrode conductors (negative electrode conductors) are provided integrally in common, and the positive electrode conductor (negative electrode conductor) of the W-phase may be provided separately from the positive electrode conductor (negative electrode conductor) of the U-phase and the V-phase.

In the above embodiment, both the positive electrode conductor 30 and the negative electrode conductor 40 are integrally configured in common with all the semiconductor modules 20 of the U-phase, V-phase, and W-phase, but the present invention is not limited to this. For example, one of the positive electrode conductor 30 and the negative electrode conductor 40 may be integrally configured in common with the U-phase, V-phase, and W-phase semiconductor modules 20, and the other of the positive electrode conductor 30 and the negative electrode conductor 40 may be configured separately for each phase.

In addition, in the above embodiment, an example in which the laminated bus bar 70 is configured by the positive electrode conductor 30, the negative electrode conductor 40, and the output conductor 60 is shown, but the present invention is not limited to this. For example, the positive electrode conductor 30, the negative electrode conductor 40, and the output conductor 60 may be disposed so as to be separated from each other by an insulating distance (may be configured so as not to be laminated).

In addition, in the above embodiment, an example is shown in which the positive electrode conductor 30, the negative electrode conductor 40, and the output conductor 60 have a flat plate shape, but the present invention is not limited to this. For example, the positive electrode conductor 30, the negative electrode conductor 40, and the output conductor 60 may have a shape other than the flat plate shape.

Further, in the above embodiment, an example in which a plurality of fuses 80 are provided in parallel is shown, but the present invention is not limited to this. For example, one fuse 80 having a relatively large capacity may be provided.

## Claims

1. A power conversion device (100) comprising:
a semiconductor module (20) that houses semiconductor elements (Q1 and Q2) inside and is provided in plurality for each phase;
a capacitor (C) that is electrically connected to the semiconductor module;
a positive electrode conductor (30) that is electrically connected to a positive electrode terminal (Cp) of the capacitor and a positive electrode terminal (C terminal) of the semiconductor module; and
a negative electrode conductor (40) that is electrically connected to a negative electrode terminal (Cn) of the capacitor and a negative electrode terminal (E terminal) of the semiconductor module, wherein
at least one of the positive electrode conductor and the negative electrode conductor is integrally configured in common to the semiconductor modules of at least a plurality of phases among the semiconductor modules of each phase and is made of aluminum.

2. The power conversion device according to Claim 1, wherein
both the positive electrode conductor and the negative electrode conductor are integrally configured in common to the semiconductor modules of each phase, and are made by the aluminum.

3. The power conversion device according to Claim 1 or 2, wherein
both the positive electrode conductor and the negative electrode conductor have a flat plate shape, and
the positive electrode conductor having the flat plate shape and the negative electrode conductor having the flat plate shape are laminated.

4. The power conversion device according to any one of Claims 1 to 3, further comprising:
output conductors (60, 60a, 60b, and 60c) that are electrically connected to an output terminal of the semiconductor module, wherein
the output conductor has a flat plate shape, is made of aluminum, and is separately provided for each phase, and
a positive electrode conductor having the flat plate shape, a negative electrode conductor having the flat plate shape, and the output conductor separately provided for each phase are laminated.

5. The power conversion device according to any one of Claims 1 to 4, further comprising:
a fuse (80) that is provided between the positive electrode conductor and the capacitor and is common to the semiconductor modules of each phase

6. The power conversion device according to Claim 5, further comprising:
a capacitor conductor (90) that is electrically connected to the positive electrode terminal of the capacitor and has a flat plate shape, wherein
the fuse is connected to the positive electrode conductor and the capacitor conductor.
